Europäisches Patentamt

European Patent Office

Office européen des brevets

(19)

(11) EP 0 732 781 B1

(12) FASCICULE DE BREVET EUROPEEN

(45) Date de publication et mention
de la délivrance du brevet:
**18.12.2002 Bulletin 2002/51**

(51) Int Cl.⁷: **H01S 5/02**, H01S 5/068,
H03L 7/26

(21) Numéro de dépôt: **95810168.5**

(22) Date de dépôt: **14.03.1995**

(54) **Module comprenant une diode laser asservie et dispositif électro-optique muni d'un tel module**

Element mit einem geregelten Diodenlaser, und elektrooptische Vorrichtung unter Verwendung eines derartigen Elements

Module comprising a controlled diode laser and electrooptical device using the same

(84) Etats contractants désignés:
**CH DE FR GB LI**

(43) Date de publication de la demande:
**18.09.1996 Bulletin 1996/38**

(73) Titulaire: **Brown & Sharpe Tesa S.A.**
**1020 Renens (CH)**

(72) Inventeurs:
• **Bezinge, Alex**
**CH-1137 Yens/VD (CH)**
• **Thomann, Pierre**
**CH-2052 Fontainemelon/NE (CH)**
• **Moser, Christophe**
**CH-1009 Pully/VD (CH)**
• **Jornod, Alain**
**CH-2013 Colombier (CH)**

(74) Mandataire: **BOVARD AG - Patentanwälte**
**Optingenstrasse 16**
**3000 Bern 25 (CH)**

(56) Documents cités:
**EP-A- 0 133 394**          **EP-A- 0 414 194**
**DE-A- 2 741 700**

• **PATENT ABSTRACTS OF JAPAN vol. 015 no. 273 (E-1088) ,11 Juillet 1991 & JP-A-03 091283 (CANON INC) 16 Avril 1991,**
• **PATENT ABSTRACTS OF JAPAN vol. 004 no. 184 (P-041) ,18 Décembre 1980 & JP-A-55 126208 (FUJITSU LTD) 29 Septembre 1980,**
• **PATENT ABSTRACTS OF JAPAN vol. 11 no. 161 (E-509) ,23 Mai 1987 & JP-A-61 292977 (HITACHI LTD)**
• **TECHNISCHE MITTEILUNGEN 85 HEFT 1, MAI 1992, pages 34-43, A. ABOU-ZEID 'Diodenlaser in der industriellen messtechnik'**

## Description

La présente invention concerne les modules comprenant une diode laser asservie en fréquence ou en longueur d'onde, et les dispositifs électro-optiques munis d'un tel module.

Depuis quelques années, grâce par exemple à l'avènement des disques compacts et des imprimantes laser, les diodes laser sont produites en très grandes séries et sont donc devenues très économiques. Dans certains domaines d'applications, elles remplacent même de plus en plus les lasers traditionnels à gaz grâce à leurs avantages importants de miniaturisation, durée de vie, rendement et facilité de mise en oeuvre.

Il existe ainsi actuellement un grand nombre de types de diodes laser différents, par exemple les diodes à structure de double hétérojonction, les diodes de type DBR (Distributed Bragg Reflector), etc..., correspondant à un grand nombre de besoins différents.

Les diodes laser à structure à double hétérojonction de type AsGaAl par exemple ont trouvé une utilisation dans un grand nombre d'applications différentes. Elles émettent une lumière laser avec une longueur d'onde entre 750nm et 880 nm, proche du spectre visible et adaptée aux récepteurs photoélectriques à silicium habituels.

La fréquence lumineuse émise par ce type de diodes dépend de deux paramètres:

- le courant d'injection fait varier la fréquence de 3 GHz/mA, soit 0.006 nm/mA.

- la température fait varier la fréquence de 30GHz/°C, soit 0.06nm/°C.

Pour beaucoup d'applications, il est nécessaire d'avoir une source laser émettant à une fréquence ou à une longueur d'onde absolument stable. C'est le cas pour des diodes laser utilisées dans des interféromètres, dans des étalons de fréquence atomique, en spectroscopie ou en télécommunications par exemple. Il est donc nécessaire dans ces applications d'utiliser soit un laser à gaz coûteux et encombrant, soit une diode laser dont la fréquence d'émission a été stabilisée.

On sait réaliser des sources de courant constant produisant un courant de 150mA avec une précision de ± 5μA. Si on applique ce courant à une diode laser, l'imprécision de fréquence vaut donc $df/f = 5 \cdot 10^{-8}$ environ.

Sur une longue durée, il est difficile de garantir une précision de la température de la diode meilleure que ± 1 mK. Cela correspond à une erreur $df/f$ de $8 \cdot 10^{-8}$

Pour certaines des applications précitées, la précision résultante par les moyens ci-dessus s'avère en pratique insuffisante. En outre, même si on parvenait à maintenir un courant et une température suffisamment constants, on ne pourrait pas avec cette méthode compenser les variations dues au vieillissement de la diode laser. Il est donc nécessaire de stabiliser la diode laser à l'aide d'un élément de référence externe.

A. Abou-Zeid, dans son article intitulé "Diodenlaser in der industriellen Meßtechnik", Technische Mitteilungen 85, Heft 1, Mai 1992, pp. 34 à 43, décrit un interféromètre utilisant une diode laser stabilisée au moyen d'un élément de référence externe.

Sur la figure 14, page 40, le faisceau lumineux émis par la diode laser est partagé au moyen d'un cube séparateur de faisceau, plus souvent désigné par la désignation anglaise beam splitter, en un faisceau de mesure et un faisceau d'asservissement. Le faisceau de mesure est utilisé dans cet article pour une application d'interférométrie. Le faisceau d'asservissement atteint un élément de référence externe, constitué sur la figure 14 par un étalon de Fabry-Perrot et sur la figure 15 par une cellule d'absorption. Un détecteur mesure l'intensité du faisceau ayant traversé l'élément de référence, et fournit un signal utilisé par des moyens de réglage pour contrôler le courant et/ou la température appliqués à la diode laser. L'élément de référence est construit de manière à atténuer sélectivement certaines longueurs d'onde ou au contraire à entrer en résonance lorsqu'une certaine longueur d'onde l'atteint. Dans la réalisation de la figure 15, la cellule d'absorption contient un gaz possédant un pic d'absorption situé très précisément à la fréquence à laquelle on souhaite caler la diode laser. Les moyens de réglage contrôlent l'émission de la diode de manière à ce que l'intensité du faisceau traversant la cellule soit minimale, ce qui revient à caler la fréquence d'émission optique de la diode laser sur la fréquence du pic d'absorption de la cellule.

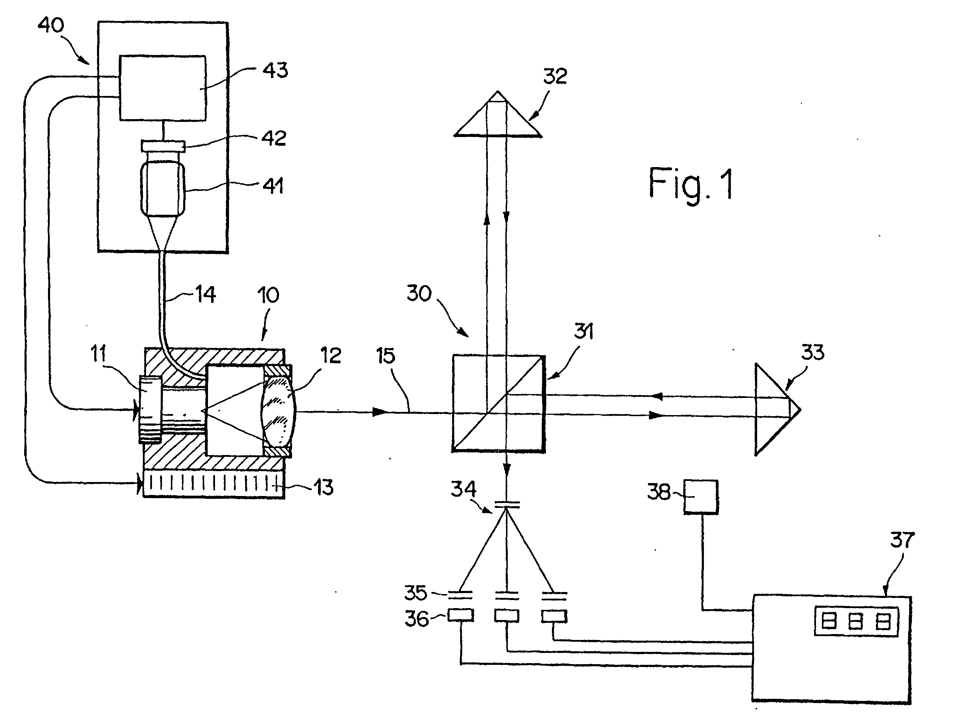

La demande de brevet EP414194 (ANRITSU Corporation) décrit un étalon de fréquence atomique utilisant une diode laser stabilisée de manière similaire. Sur la figure 1b en particulier, dans l'élément 24, on voit que le faisceau de la diode laser est partagé au moyen d'un cube séparateur de faisceau en un faisceau de mesure et un faisceau d'asservissement. Le faisceau d'asservissement atteint un résonateur optique 24d et un détecteur optique 24e fournit un signal utilisé par des moyens de contrôle 24f, 24g, 24h, 24i pour contrôler le courant d'injection de la diode laser, de manière à ce qu'elle émette précisément à la fréquence de résonance du résonateur optique 24e. Dans cette application, le faisceau de mesure est utilisé pour pomper optiquement des atomes dans une cellule de résonance 21 C.

Ces deux solutions présentent toutefois un certain nombre d'inconvénients rendant leur utilisation problématique. Une partie du faisceau lumineux émis par la diode laser est réfléchie par la surface du cube séparateur et renvoyée vers la diode laser. Ce feed-back de lumière dans la diode laser modifie certaines caractéristiques d'émission, telles que la longueur d'onde ou le mode d'émission, et rend donc la stabilisation très difficile. Plusieurs solutions ont été proposées pour réduire, mais pas éliminer, le feed-back indésirable, en traitant les faces du cube séparateur avec des couches anti-réfléchissantes, en désalignant le cube par rapport à l'axe optique ou en utilisant un isolateur optique, comme indiqué par exemple à la page 37, colonne de gauche, du document de Abou-Zeid. Ces opérations permettent certes d'améliorer le dispositif, mais entraînent des complications et un surcoût.

De surcroît, lors de variations de température, la distance entre la diode laser et l'interface du cube séparateur se modifie en raison des dilatations. La phase et/ou l'amplitude de la lumière renvoyée dans la diode laser dépend donc de la température, rendant le comportement du dispositif difficilement prévisible.

En outre, le positionnement des divers composants est compliqué dans ces deux réalisations. La cellule d'absorption, dont le volume suivant le gaz choisi peut être assez important, doit être positionnée dans le chemin optique du faisceau lumineux, c'est-à-dire à proximité de la diode laser et du circuit de mesure. Si la diode laser est placée sur un circuit imprimé, il peut être difficile d'y fixer et d'ajuster correctement la cellule d'absorption. En outre, et particulièrement dans la réalisation du brevet EP414194, le détecteur optique 24e peut être perturbé par les champs électromagnétiques provoqués par les composants de l'étalon atomique, notamment par le générateur de micro-ondes. La valeur mesurée par ce détecteur peut alors être faussée, et la stabilisation de la diode laser s'en trouver affectée.

De surcroît, il est difficile de stabiliser thermiquement la diode laser et la cellule au rubidium indépendamment l'un de l'autre.

Dans les deux réalisations précitées, le cube séparateur partage le faisceau lumineux émis par la diode laser en deux faisceaux, de mesure et d'asservissement, d'intensité sensiblement égale. Or les moyens d'asservissement peuvent généralement se contenter d'une petite fraction de l'intensité lumineuse nécessaire au reste du dispositif électro-optique. Dans une application d'interférométrie typique, le circuit d'asservissement pourrait se contenter de 2 ou 3 % environ de l'intensité lumineuse requise par l'interféromètre, alors que dans ces réalisations il reçoit la même intensité. La diode laser doit donc fonctionner à une puissance inutilement élevée, ce qui réduit sa longévité, accélère le vieillissement, produit un échauffement intempestif et gaspille de l'énergie.

Le brevet EP479118 (Dornier) décrit un dispositif dans lequel le faisceau lumineux d'asservissement nécessaire à l'asservissement d'une diode laser est prélevé au moyen d'une fibre optique placée directement devant la diode laser. Il est possible avec cette solution de positionner la diode laser très librement par rapport au reste du dispositif.

Toutefois, ce dispositif utilise une fibre optique de type monomode, difficile à mettre en oeuvre et nécessitant des précautions pour l'alignement avec la diode laser. En outre, une fibre monomode n'est pas apte à transporter un faisceau lumineux d'une certaine intensité. Ce dispositif est donc seulement adapté à des dispositifs dans lesquels l'intensité exigée du faisceau lumineux de travail est faible, par exemple dans ce document pour des capteurs à fibre optique.

En outre, cette solution ne fait que déplacer les problèmes liés à la séparation de faisceau lumineux loin de la diode laser. Pour effectuer la séparation entre le faisceau lumineux de travail et le faisceau lumineux d'asservissement, il est cependant également nécessaire dans cette réalisation de prévoir un élément de type séparateur de faisceau, sous la forme ici de coupleur de fibres optiques. Ce type de coupleur est cependant au moins aussi difficile à produire qu'un cube séparateur de faisceau. La lumière pénétrant les coupleurs de type connus traverse une interface optique qui renvoie au travers de la fibre optique une partie de la lumière vers la diode laser.

Tel qu'il est effectué, le couplage d'une fibre monomode à une cavité de Fabry-Perot génère un feedback très important. Il n'est donc pas possible d'utiliser l'enseignement de ce brevet pour des applications sensibles aux problèmes de sauts de mode.

Finalement, cette solution ne résout pas davantage que les précédentes le problème de la puissance à fournir à la diode laser. Les coupleurs de fibre optique courants partagent en effet le faisceau lumineux entrant en deux faisceaux d'intensité égale. Les moyens d'asservissement reçoivent par conséquent une intensité lumineuse égale au reste du dispositif, quand bien même ils pourraient dans beaucoup d'applications se contenter d'une fraction de cette intensité.

Un but de l'invention est donc de prévoir un module laser muni d'une diode laser asservie, qui conserve l'avantage de la facilité de placement de la diode laser, tout en évitant les inconvénients mentionnés. En particulier, un des problèmes résolus par l'invention concerne le prélèvement au moyen d'une fibre optique de la lumière nécessaire à l'asservissement de la diode laser avec un minimum de feed-back et de perturbations pour la diode laser. Un autre but est de réaliser un module laser simple et peu onéreux.

Un autre problème que l'invention se vise de résoudre concerne la limitation de la puissance qu'il est nécessaire de fournir à la diode laser.

L. Pujol et al., dans l'article intitulé "Interféromètre intégré stabilisé par absorption atomique", présenté à la conférence OPTICS 92 (Paris), décrivent un module laser stabilisé par absorption atomique qui évite certains des inconvénients précités. Dans ce document, la diode laser est une diode laser de type Fabry-Perot émettant de la lumière sur ses deux faces. La lumière émise par la face avant constitue le faisceau lumineux de travail utilisé pour l'application spécifique, ici pour un dispositif de mesure de longueur par interférométrie, alors que la lumière émise par la face arrière est récupérée par une fibre optique et conduite vers des moyens d'asservissement qui peuvent ainsi être délocalisés. Le faisceau lumineux d'asservissement ne traverse donc aucune interface optique entre la diode laser et les moyens d'asservissement, ce qui permet de supprimer une des sources de feed-back de lumière dans la diode laser.

Cependant, cette solution pose également un certain nombre de problèmes. En effet, même si théoriquement toutes les diodes laser à cavité de Fabry-Perot peuvent émettre de la lumière à la fois sur la face arrière et sur la face avant, la majorité des diodes commerciales présentes sur le marché sont optimisées et encapsulées de manière à émettre de la lumière par la face avant seulement. Seules quelques diodes, onéreuses et disponibles en choix restreint, sont aptes à émettre par leurs deux faces.

De surcroît, le placement de la diode laser devient tout à fait critique, puisqu'elle doit être alignée à la fois sur sa face avant avec le dispositif d'optique intégrée et sur sa face arrière avec la fibre optique. Ces deux éléments se caractérisent par une ouverture optique limitée, ce qui nécessite donc un usinage soigneux du module laser.

Enfin, dans cette solution, la lumière émise par la diode laser pénètre directement dans un circuit optique intégré réalisant la fonction d'interférométrie. Une partie de la lumière émise est réfléchie à l'interface du circuit intégré et renvoyée vers la diode laser. Cette solution ne résout donc absolument pas le problème du feed-back, ni celui de la variation du comportement avec la température suite aux variations de l'indice de réflexion.

DE-A-27 41 700 (voir la figure 1) décrit un module laser contenant une diode laser et une fenêtre, la diode laser émettant par sa face avant un faisceau lumineux qui traverse la fenêtre de manière à constituer un faisceau lumineux de travail, un faisceau lumineux d'asservissement constitué par une partie de la lumière émise par la face avant de la diode laser qui traverse la fenêtre après multiples réflexions à l'intérieur de la fenêtre, le faisceau lumineux d'asservissement étant conduit au moyen d'une fibre optique vers des moyens d'asservissement de la diode laser pour déterminer au moins un paramètre de fonctionnement de la diode laser.

Un but de l'invention est de prévoir un autre type de module à diode laser asservie, dans lequel le chemin optique parcouru par le faisceau lumineux d'asservissement entre la diode laser et les moyens d'asservissement ne comporte aucun élément de type séparateur de faisceau. De manière générale, l'invention a pour but un dispositif dans lequel toutes les sources de feed-back dans la diode laser sont réduites autant que possible.

Un autre problème que l'invention se vise de résoudre concerne la réalisation d'un module laser de ce type à l'aide de diodes laser couramment disponibles commercialement, et ne nécessitant pas de précautions particulières lors de la fabrication ou du montage. Avantageusement, l'invention a pour but un dispositif pouvant être réalisé avec des diodes laser ordinaires de type Fabry-Perot, DBR ou à cavité verticale (VCSEL).

Un autre problème que l'invention se vise de résoudre concerne les variations de réflexions et de feed-back dues aux variations de température notamment de la lentille devant la diode laser.

L'invention a ainsi pour objet un module laser selon le document de Pujol et al., mais qui ne présente pas les inconvénients mentionnés. Ce but est atteint grâce aux éléments de la partie caractérisante de la première revendication. En particulier, selon une première caractéristique de l'invention, le dis- positif est caractérisé en ce que le faisceau lumineux d'asservissement est prélevé au moyen d'une fibre optique couplée au module laser de manière à récolter une partie de la lumière émise par la face avant de la diode laser qui ne traverse pas la lentille devant la diode laser. On récupère grâce à cette fibre optique quelques pourcents de la lumière émise et aussitôt perdue, par exemple à la suite des réflexions et diffusions sur la première lentille.

On évite de cette manière d'utiliser un élément de type séparateur de faisceau pour prélever le faisceau d'asservissement, et on supprime ainsi une des sources importantes de feed-back. En outre, on peut se contenter d'utiliser des diodes laser de type courant émettant par la face avant.

Les variantes de l'invention illustrent plusieurs façon de placer la fibre optique devant la diode laser de manière à prélever le faisceau lumineux d'asservissement en perturbant le moins possible la diode laser.

La fibre optique permet de séparer clairement les fonctions d'asservissement et de mesure ou de transmission, et les réaliser au moyen de modules distants physiquement. La construction du dispositif et le positionnement des divers modules sont ainsi facilités, et il est plus facile de protéger les différents modules d'influences électromagnétiques réciproques ou de l'extérieur.

Avantageusement et selon l'application, le faisceau lumineux d'asservissement représente seulement une faible fraction de la lumière émise par la diode laser, de préférence moins de dix pour-cent. Grâce à cette caractéristique, il est possible de limiter la puissance de fonctionnement de la diode laser.

Selon une autre caractéristique de l'invention, la diode laser est stabilisée en fréquence. Cette caractéristique permet de limiter les variations de fréquence de la diode laser, dues par exemple aux variations de la température ambiante, aux variations intempestives du courant d'injection ou au vieillissement de la diode laser.

Selon une autre caractéristique de l'invention, la cellule de référence est constituée par une cellule d'absorption contenant un gaz possédant un pic d'absorption spectral auquel la fréquence de la lumière émise par la diode est asservie.

Selon une autre caractéristique de l'invention, le module laser comporte en outre des moyens permettant de contrôler simultanément la température de la diode laser et de la lentille.

Dans une première variante de l'invention, le faisceau lumineux d'asservissement est transporté par une fibre optique jusqu'aux moyens d'asservissement alors qu'un dispositif de mesure ou de communications utilise directement le faisceau lumineux de travail à la sortie de la diode laser.

Dans une deuxième variante de l'invention, le faisceau lumineux d'asservissement est transporté par une fibre optique jusqu'aux moyens d'asservissement alors que le faisceau lumineux de travail est transporté par une deuxième fibre optique jusqu'au dispositif de mesure ou de communications.

D'autres avantages et caractéristiques de l'invention sont mentionnés dans les revendications annexées ainsi que dans la description et dans les figures, parmi lesquelles:

- La figure 1 montre une première variante de l'invention appliquée à un interféromètre.

- La figure 2 montre la même variante de l'invention appliquée à un étalon atomique de fréquence.

- La figure 3 est une vue détaillée du module laser selon la première variante de l'invention.

- La figure 4 montre une deuxième variante de l'invention appliquée à un étalon de fréquence atomique.

La description qui suit est illustrée à l'aide d'applications dans le domaine de l'interférométrie, puis dans celui des étalons de fréquence atomique. Il est cependant aussi possible d'appliquer l'invention pour d'autres applications utilisant des modules lasers stabilisés en fréquence ou en longueur d'onde, par exemple des applications dans le domaine de la spectroscopie ou des télécommunications par fibre optique.

La figure 1 illustre une première variante de l'invention, appliquée à titre d'exemple à un interféromètre de Michelson 30. De tels interféromètres sont utilisés pour effectuer des mesures de longueur avec une très grande i précision, de l'ordre de grandeur de 0.01 à 0.1 microns environ. Ils peuvent être intégrés dans divers dispositifs de mesure de longueur, de hauteur, de déplacement, etc..., en laboratoire ou en milieu industriel. Il est cependant aussi possible d'utiliser des interféromètres analogues pour effectuer des mesures de très grandes distances, notamment dans la technique spatiale pour mesurer des distances ou des éloignements d'objets ou de corps célestes dans l'espace, par exemple des distances ou des positions de satellites artificiels.

Le faisceau lumineux de travail 15 émis par la diode laser 11 dans le module laser 10 est partagé par un élément 31 de type cube séparateur de faisceau (aussi souvent désigné par la terminologie anglaise beam splitter) en deux faisceaux. Un premier faisceau, dit faisceau de référence, est dirigé contre un miroir fixe 32, ou miroir de référence, alors que l'autre faisceau, dit faisceau objet, est dirigé contre un miroir mobile 33, lié à un objet dont on souhaite mesurer la position ou le déplacement. Les deux faisceaux réfléchis sont renvoyés contre le cube séparateur où ils se recombinent en créant un motif d'interférences. Un détecteur à franges, comportant un réseau de diffraction 34, des polariseurs 35 et des détecteurs optiques 36 fournit des signaux à une unité de calcul et de traitement 37. Ces signaux dépendent du motif d'interférence crée par la recombinaison du faisceau objet avec le faisceau de référence, et fournissent ainsi une indication très précise de la position du miroir mobile 33.

Le principe de tels interféromètres est bien connu dans l'art antérieur. Comme la précision de la mesure dépend directement de la stabilité de la longueur d'onde du faisceau lumineux, on fait souvent appel à un laser à gaz comme source laser, ce qui limite l'utilisation de cette technique de mesure à des applications dans lesquelles les contraintes de coût, de volume et de consommation ne sont pas trop cruciales.

Il est aussi possible d'utiliser comme source lumineuse des diodes laser stabilisées en fréquence ou en longueur d'onde. Comme indiqué ci-dessus, ces diodes laser sont très sensibles à la lumière réfléchie et renvoyée dans la diode.

Pour cette raison, il est nécessaire de concevoir l'interféromètre de sorte que la quantité de lumière renvoyés dans la diode soit minimale. Les miroirs 32 et 33 sont de préférence réalisés à l'aide de rétroréflecteurs en forme de coin de cube. Ces éléments ont la propriété de renvoyer un faisceau réfléchi parallèle au rayon incident, mais non confondu. Ils sont de préférence traités avec une couche anti-réfléchissante. Dans une variante, il est aussi possible d'utiliser un prisme droit ou une bille comme miroir. Selon l'application, le miroir mobile 33 peut cependant aussi être constitué simplement par une surface réfléchissante ou métallique de l'objet mesuré.

Les éléments optiques 31 à 35 sont de préférence réalisés avec des composants optiques discrets plutôt qu'en optique intégrée. L'avantage de l'optique discrète est de supprimer le saut d'interface subi par le faisceau de mesure 15 à l'entrée de l'élément d'optique intégrée. On évite ainsi une cause supplémentaire de feed-back vers la diode laser. En outre, pour des séries petites ou moyennes, la technologie discrète est plus économique que la technologie intégrée.

Les autres éléments susceptibles de réfléchir de ta lumière vers la diode laser, comme le cube séparateur 31, sont soigneusement traités avec des couches anti-réfléchissantes et désalignés de quelques degrés par rapport à l'axe optique. L'invention permet par rapport à la réalisation de Abou-Zeid de supprimer un des deux cubes séparateurs de faisceaux.

Pour obtenir une précision de mesure suffisante avec une diode laser, il est nécessaire de la stabiliser afin de la rendre aussi insensible que possible aux variations de température ou de milieu par exemple. Dans l'art antérieur, on asservissait la longueur d'onde de la lumière émise par la diode laser à une référence externe, de manière à ce que la diode émette toujours une lumière de longueur d'onde aussi constante que possible.

En négligeant le vieillissement, on peut considérer qu'une diode laser émet pour une température constante et un courant d'injection constant une lumière de fréquence constante. La fréquence f et la longueur d'onde λ sont liées par la relation

$$\lambda = \frac{c}{\eta_{milieu} \cdot f}$$

où c désigne la vitesse de la lumière dans le vide et $n_{milieu}$ l'indice de réfraction du milieu. Dans l'air l'indice de réfraction dépend de la température, de la pression et de la pression de vapeur d'eau selon la relation d'Edlen:

$$n = 1 + \frac{79 \cdot 10^6}{T} \cdot (p + \frac{4800e}{T})$$

où T est la température en Kelvin, p la pression en mBar et e la pression de vapeur d'eau en mBar.

Lorsque le courant d'injection de la diode laser reste constant on voit donc que la longueur d'onde émise dépend de l'indice de réfraction du milieu. Dans les dispositifs de stabilisation de la longueur d'onde, il est nécessaire de compenser en permanence les variations de température et de pression de l'air par des modifications du courant d'injection de la diode laser.

Les diodes laser stabilisées en longueur d'onde le sont généralement au moyen d'une cavité optique ("étalon") qui ne se trouve pas physiquement sur le chemin optique du faisceau de travail, dont la longueur d'onde doit être stabilisée. Pour fonctionner correctement, cette technique de stabilisation suppose donc une température homogène de l'ensemble du dispositif, ce qui est très difficile à réaliser en pratique, notamment pour des interféromètres de grande dimension.

Selon une caractéristique de l'invention, la diode laser est stabilisée en fréquence plutôt qu'en longueur d'onde. La diode laser est donc asservie de manière à ce que la fréquence de la lumière émise reste constante. La longueur d'onde de la lumière émise par contre varie en suivant les variations de température et de pression. Dans un exemple d'application pour un interféromètre, le déplacement mesuré dépend donc de l'indice de réfraction sur le chemin du faisceau de travail.

Pour obtenir une précision de mesure optimale, il est donc nécessaire de corriger la mesure de longueur calculée. Un capteur 38 de température, de pression et/ou de pression de vapeur d'eau permet de mesurer ces paramètres et de les fournir à l'unité de calcul et de traitement 37 qui effectue la correction par exemple grâce à un algorithme ou à une table de correction.

De cette manière, on sépare le problème de la stabilisation de la diode laser et celui de la correction de l'indice de réfraction, qui peuvent donc être réglés par deux modules distincts.

En principe, on peut envisager d'utiliser divers types de diodes laser dans le module laser, par exemple des diodes laser à cavité de Fabry-Perot, des diodes DBR ou des diodes à cavité verticale. Dans les exemples de réalisation, la diode laser 11 utilisée est une diode laser à structure à double hétéro-jonction, de type AsGaAl. La diode laser est optimisée et encapsulée de manière à émettre de la lumière sur une seule face, désignée comme la face avant. Une lentille de collimation 12 permet de collimater le faisceau lumineux et de le diriger vers l'interféromètre. Des moyens de contrôle thermique 13 permettent de contrôler la température de l'ensemble du module laser. Une fibre optique 14, placée d'une manière que l'on verra plus en détail plus loin, capte une portion de la lumière émise par la face avant de la diode. Cette portion est désignée comme le faisceau d'asservissement.

Les moyens d'asservissement 40 comportent une cellule d'absorption 41 contenant une vapeur possédant un pic d'absorption spectral. Le spectre d'absorption du rubidium 87 par exemple possède une raie à laquelle la fréquence d'émission de la diode peut être asservie. D'autres gaz peuvent cependant être utilisés, par exemple d'autres isotopes ou mélanges de rubidium, de césium, de vapeur d'eau ou n'importe quel autre élément possédant un pic d'absorption.

Il est aussi possible de stabiliser la diode laser sur d'autres types de cellules de référence que des cellules d'absorption, par exemple sur des étalons de Fabry-Perot ou sur des résonateurs optiques.

Le faisceau d'asservissement est guidé par la fibre optique 14 jusqu'à la cellule de référence 41. La lumière traversant la cellule est mesurée par un détecteur optique 42 placé du côté opposé à la cellule.

La lumière reçue par le détecteur 42 est minimale lorsque la fréquence lumineuse est égale à la fréquence du pic d'absorption du gaz de la cellule d'absorption, c'est-à-dire lorsque l'absorption est maximale. Le détecteur optique 42 fournit un signal aux moyens de contrôle 43 du courant de la diode laser 11. Ces moyens permettent de contrôler le courant d'injection appliqué à la diode laser de manière à ce que le signal reçu par le détecteur optique 42 soit toujours minimal, c'est-à-dire de manière à ce que la fréquence lumineuse émise corresponde à la fréquence d'absorption du gaz dans la cellule d'absorption.

Dans une réalisation préférentielle, les moyens de contrôle agissent uniquement sur le courant d'injection appliqué à la diode laser 11, afin de varier la fréquence lumineuse émise. Il est cependant aussi tout à fait possible de stabiliser la fréquence lumineuse émise en agissant grâce aux moyens de contrôle 13 sur la température de la diode laser, ou d'agir simultanément sur la température et sur le courant d'injection de la diode laser.

En agissant sur le courant d'injection de la diode laser, on modifie la fréquence d'émission de la diode laser, mais aussi l'intensité lumineuse émise. Si le pic d'absorption du gaz utilisé n'est pas très raide, le détecteur 42 risque alors de détecter des variations davantage dues à la variation d'amplitude qu'à la variation de fréquence. Il peut alors être nécessaire d'effectuer une correction, soit en la prévoyant dans les moyens de contrôle 43, soit, comme décrit sur les figures 14 et 15 du document de Abou-Zeid, en effectuant une soustraction du signal mesuré avant la cellule d'absorption avec le signal mesuré après.

Le module laser décrit peut aussi être utilisé pour régler d'autres paramètres de fonctionnement de la diode laser que la fréquence ou la longueur d'onde. Par exemple, en modifiant les moyens d'asservissement 40, il est possible de stabiliser l'intensité lumineuse émise par la diode laser.

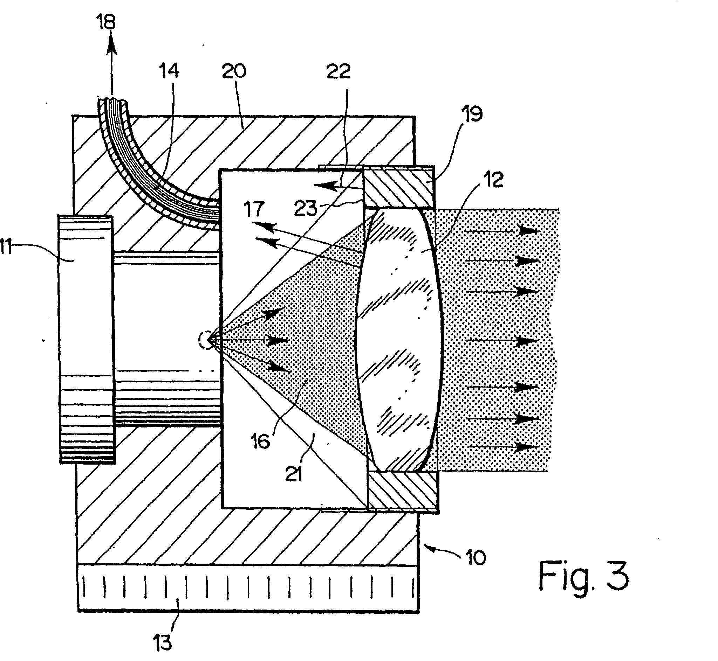

A l'aide de la figure 3, nous allons maintenant étudier plus en détail le module laser et le principe du couplage de la fibre optique selon la première variante de l'invention.

Le module laser 10 comprend un boîtier 20 stabilisé en température grâce à des moyens de contrôle thermique 13. Ces moyens de contrôle thermique sont de préférence constitués par un élément Peltier. La diode laser 11, encapsulée de manière à émettre un faisceau de lumière 16 par la face avant uniquement, est fixée dans une ouverture du boîtier 20. Une lentille de collimation 12 placée devant la diode laser permet de récolter la lumière divergente émise par la diode laser et de la collimater en un faisceau émis 15. Cette lentille est fixée au boîtier 20 au moyen d'un support de lentille 19 réalisé en matériau synthétique ou de préférence en métal. La lentille elle-même peut être réalisée en matériau synthétique ou en verre; la forme de la lentille est seulement représentée schématiquement sur la figure. La lentille 12 peut éventuellement aussi être constituée par un groupe de lentilles.

Les réflexions provoquées par la surface de la lentille de collimation 12 et renvoyées vers la diode laser sont peu gênantes dans la mesure où la lentille est placée très près de la diode laser. Ce type de feed-back est moins critique pour la diode laser. Néanmoins, en vue de minimiser les réflexions, la lentille 12 peut être revêtue de couches anti-réflexions.

Selon une caractéristique de l'invention, tes moyens de contrôle thermique 13 sont disposés de manière à contrôler simultanément la température de la diode laser 11 et celle de la lentille 12. Cette configuration permet de maintenir une température de la diode laser, de la lentille et de l'espace inter-médiaire constante. Le feed-back optique dû à la lentille reste de cette manière absolument constant en phase et en amplitude, évitant ainsi des sauts de mode d'émission.

Afin de limiter au maximum les transferts de chaleur, un vide d'air peut être créé dans la cavité entre la diode laser 11 et la lentille 12. Il est aussi possible de remplir cet espace avec un gaz tel que le xénon limitant les transferts de chaleur, comme cela est connu par exemple du brevet US5195102 (McLean et al.) ou de la demande de brevet FR9203210.

Selon l'invention, une fibre optique 14 est placée dans le boîtier 20 de façon à récolter une partie de la lumière 17 réfléchie ou diffusée par la lentille 12. Si une partie 21 de la lumière émise par la diode laser atteint aussi le support de lentille 19, la fibre optique peut aussi être placée de manière à capter une partie 22 de la lumière réfléchie ou diffusée par ce support. Dans ce but, le support de lentille 19 peut être réalisé en métal poli sur une partie 23 de sa surface, ou même recouvert au moins partiellement de miroirs. Comme la quantité de lumière nécessitée par les moyens d'asservissement est très faible, il est cependant généralement suffisant que la fibre optique soit placée de manière à récolter uniquement une partie de la lumière réfléchie par la surface de la lentille de collimation. Des expériences ont été effectuées qui ont montré qu'il est ainsi possible de récolter quelques pour-cent de la lumière émise par la diode laser, ce qui est généralement suffisant pour l'asservissement. Si l'on néglige la lumière perdue dans le module laser, on a donc que l'intensité du faisceau lumineux de travail (15) représente presque la totalité de l'intensité de la lumière (16, 21) émise par la diode laser (11).

La fibre optique 14 ainsi couplée permet de récolter sans perturber la diode laser le faisceau lumineux d'asservissement 18 d'une intensité suffisante au fonctionnement des moyens d'asservissement 40. De préférence, on utilisera une fibre multimode plus économique et captant davantage de lumière qu'une fibre monomode.

Un diaphragme, non représenté, peut être placé sur le chemin optique après la lentille 12, afin de contrôler la quantité de lumière émise et la qualité du faisceau.

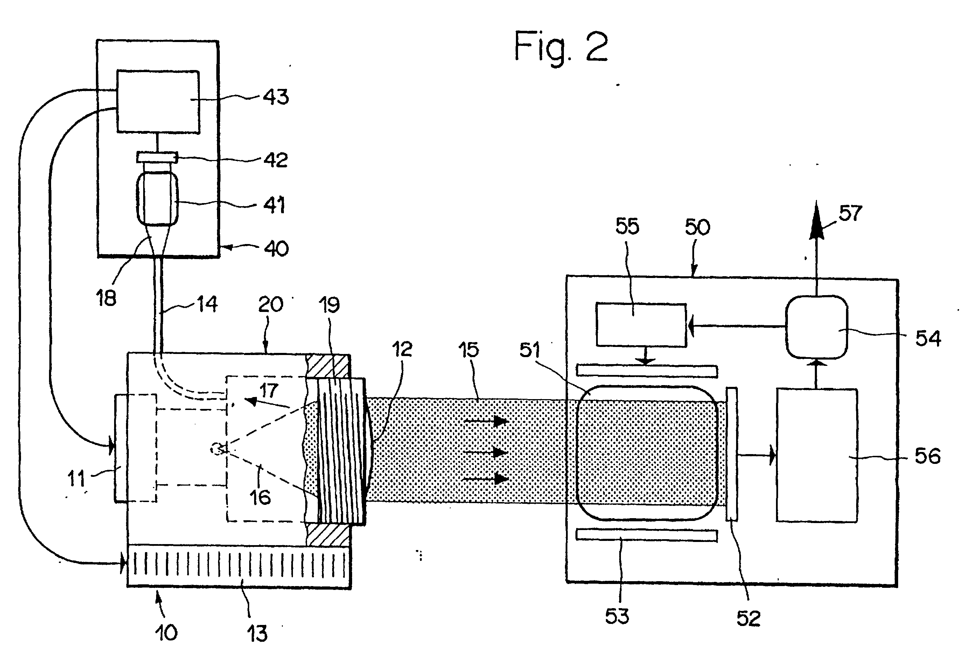

Nous allons maintenant étudier à l'aide de la figure 2 l'application de la même variante de l'invention dans un étalon de fréquence atomique.

De tels étalons de fréquence atomique sont connus notamment du brevet déjà mentionné EP414194 ou de la demande de brevet française FR9203210 au nom de l'Observatoire Cantonal de Neuchâtel. On se référera donc utilement à ces deux documents pour une étude plus détaillée de leur fonctionnement, et seuls les caractéristiques nécessaires à la compréhension de l'invention proprement dite sont reprises ici.

De la même manière que pour l'interféromètre décrit en relation avec la figure 1, l'étalon de fréquence atomique comprend un module laser 10 asservi en fréquence sur une cellule contenant une vapeur atomique ou moléculaire (par exemple du rubidium ou du césium). Le module laser 10 émet un faisceau lumineux de travail 15 atteignant l'étalon de fréquence atomique 50. De manière tout à fait similaire à ce qui a été décrit ci-dessus, un faisceau lumineux d'asservissement 18 est prélevé au moyen d'une fibre optique multimode 14 directement couplée dans le module laser de manière à prélever une partie de la lumière émise par la face avant de la diode laser et réfléchie et/ou diffusée par la lentille 12 et en plus le cas echéant par le support de lentille 19.

Des moyens d'asservissement 40, similaires à ceux décrits ci-dessus, permettent de régler le courant d'injection de la diode laser et/ou sa température, de manière à stabiliser la fréquence de la lumière émise 16. Ces moyens d'asservissement sont de préférence localisés dans un module séparé, afin de les mettre à l'écart des perturbations thermiques et électromagnétiques causées par le module laser 10 et par l'étalon atomique 50.

Le faisceau lumineux de travail 15 est utilisé dans l'étalon atomique de fréquence 50 pour pomper optiquement une cellule de résonance 51 dans résonateur atomique. La cellule de résonance contient une vapeur atomique, par exemple du rubidium ou du césium, et est traversée par le faisceau lumineux de travail 15. Un photodétecteur 52 capte la lumière transmise par la cellule.

La cellule 51 est placée dans un résonateur radiofréquence 53 alimenté par un oscillateur à quartz 54 dont la fréquence est multipliée par un facteur prédéterminé adéquat dans un multiplicateur de fréquence 55. Ce multiplicateur de fréquence remplit une double fonction de multiplicateur de fréquence et de synthétiseur. L'oscillateur fournit également le signal de sortie 57, caractérisé par une fréquence très stable et très bien définie.

Lorsque la fréquence de la lumière 15 atteignant la cavité est voisine de la fréquence de résonance caractéristique de l'espèce atomique contenue dans la cellule de résonance 51, l'intensité lumineuse transmise et reçue par le photodétecteur 52 varie de manière résonante.

Le signal délivré par ce photodétecteur 52 est traité par un dispositif d'asservissement électronique 56 pour corriger la fréquence de l'oscillateur à quartz 54 et maintenir celle-ci dans le rapport prédéterminé avec la fréquence de résonance radio caractéristique de la vapeur atomique. Dans cet exemple, la fréquence de l'oscillateur à quartz vaut 5MHz et est augmentée par le multiplicateur 55 à 6835MHz. Cette valeur correspond à la fréquence de résonance de la cellule lorsqu'elle est remplie avec l'isotope 87 du rubidium.

Dans cet exemple, le résonateur est un résonateur atomique à cellule de rubidium. L'invention s'applique cependant aussi à des résonateurs à cellule de césium ou de n'importe quel autre vapeur atomique ou moléculaire, ou de mélange de vapeurs. Ce pourrait aussi être un résonateur à jet atomique, par exemple à jet de rubidium ou de césium.

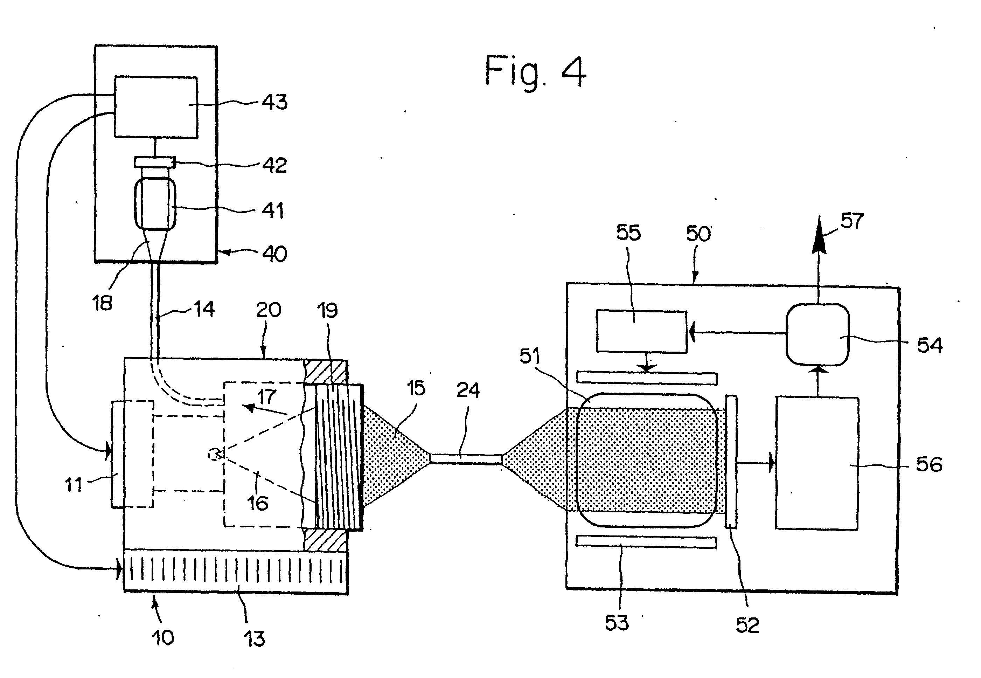

La figure 4 illustre une deuxième variante de l'invention, toujours appliquée à titre d'exemple au cas de l'étalon atomique de fréquence, qui permet une plus grande liberté pour le positionnement du module laser tout en conservant les avantages de la première variante illustrée par les figures 1 et 2.

Dans cette variante, la lentille de collimation est remplacée par une lentille de focalisation permettant le couplage du module laser 10 à une fibre optique multimode 24. Des moyens de contrôle de température 13 règlent simultanément la température de la diode laser 11 et de la lentille devant la diode laser. Le faisceau lumineux de travail est transporté par une fibre optique 24 jusqu'à l'étalon atomique de fréquence 50. De la même manière que précédemment, le faisceau lumineux d'asservissement 18 est transporté jusqu'aux moyens d'asservissement 40 par une fibre optique 14 directement couplée au module laser, de manière à récolter une partie de la lumière émise par la face avant de la diode laser 11 et réfléchie et/ou diffusée par la lentille et en plus le cas échéant par le support de lentille 19. Les autres éléments du module laser 10 sont identiques à ceux de la première variante.

Cette variante permet de placer le module laser 10 dans un endroit à l'abri des perturbations électromagnétiques ou thermiques causées par le dispositif 30 ou 50, et de faciliter la construction et l'alignement du dispositif.

Cette deuxième variante est particulièrement adaptée à une application du module laser 10 comme émetteur optique sur fibre optique. La fibre optique 24 est alors une fibre de transmission d'informations. On choisira de préférence pour cette application une fibre optique 24 monomode. Ce type de fibre permet en effet un débit d'informations supérieur aux fibres multimodes. Le couplage d'une fibre optique monomode est plus délicat que celui d'une fibre multimode, en raison notamment de leur ouverture réduite. Des précautions supplémentaires de couplage non détaillées ici, mais connues de l'homme du métier, seront donc nécessaires. Pour cette application, les moyens de contrôle 43 du courant d'injection de la diode laser comprennent en outre des moyens de modulation analogiques ou numériques.

**Revendications**

1.  Module laser (10) contenant une diode laser (11) et une lentille (12), la diode laser émettant par sa face avant un faisceau lumineux qui traverse la lentille de manière à constituer un faisceau lumineux de travail (15), un faisceau lumineux d'asservissement (18) constitué par une partie (17) de la lumière émise par la diode laser étant conduit au moyen d'une fibre optique (14) vers des moyens d'asservissement (40) de la diode laser, les moyens d'asservissement utilisant le faisceau lumineux d'asservissement pour déterminer au moins un paramètre de fonctionnement de la diode laser, **caractérisé en ce que**

- la lentille (12) se trouve devant la face avant de la diode laser et est placée très près de la diode laser (11) de manière à rendre peu gênantes les réflexions renvoyées de la lentille vers cette diode laser (11), et

- la fibre optique (14) est couplée au module laser (10) de manière à récolter une partie de la lumière émise par la face avant de la diode laser qui, sans traverser la lentille, est issue de réflexions et/ou diffusions sur la lentille (12), au moins cette partie de la lumière constituant le faisceau lumineux d'asservissement.

2. Module laser selon la revendication 1, **caractérisé en ce que** les moyens d'asservissement utilisent le faisceau lumineux d'asservissement pour déterminer le courant d'injection et/ou la température de la diode laser (11) de manière à stabiliser la fréquence ou la longueur d'onde de la lumière (16) émise par la diode laser.

3. Module laser selon l'une des revendications précédentes, **caractérisé en ce que** le chemin optique entre la diode laser (11) et les moyens d'asservissement (40) ne comporte aucun élément de type séparateur de faisceau.

4. Module laser selon l'une des revendications précédentes, **caractérisé en ce que** le module laser comporte en outre des moyens de contrôle de température (13) permettant de contrôler simultanément la température de la diode laser (11) et de la lentille (12).

5. Dispositif électro-optique de mesure ou de transmission comportant un module laser (10) selon l'une des revendications précédentes, dans lequel le faisceau lumineux de travail est utilisé pour effectuer une mesure ou une transmission.

6. Dispositif selon la revendication précédente, **caractérisé en ce que** les moyens d'asservissement comportent:

- un élément de référence (41),
- des moyens de détection optique (42),
- ainsi que des moyens de contrôle (43) du courant d'injection et/ou de la température de la diode laser,

le faisceau lumineux d'asservissement étant guidé par ladite fibre optique (14) de manière à traverser l'élément de référence et à atteindre les moyens de détection optique.

7. Dispositif selon la revendication précédente, **caractérisé en ce que** l'élément de référence (41) est constituée par une cellule d'absorption contenant une vapeur atomique ou moléculaire et possédant un pic d'absorption spectral auquel la fréquence de la lumière (16) émise par la diode laser (11) est asservie.

8. Dispositif électro-optique selon l'une des revendications 5 à 7, **caractérisé en ce que** le faisceau lumineux (15) de travail traverse après la lentille (12) des composants optiques discrets (31, 32, 33, 34, 35), désalignés par rapport à l'axe optique de manière à limiter le feed-back dans la diode laser.

9. Dispositif selon l'une des revendications 5 à 8, **caractérisé en ce qu'**une deuxième fibre optique (24) est couplée au module laser (10), et **en ce que** le faisceau lumineux de travail est conduit par ladite deuxième fibre optique (24).

10. Dispositif selon l'une des revendications 5 à 9, **caractérisé en ce qu'**il constitue un interféromètre utilisant comme source lumineuse le faisceau lumineux de travail (15).

11. Dispositif selon l'une des revendications 5 à 9, **caractérisé en ce qu'**il constitue un étalon atomique de fréquence, et **en ce que** le faisceau lumineux de travail (15) est utilisé pour pomper optiquement une cellule de résonance (51).

12. Dispositif selon l'une des revendications 5 à 9, **caractérisé en ce qu'**il constitue un émetteur de transmission sur fibre optique (24) utilisant comme source lumineuse le faisceau lumineux de travail (15).

13. Dispositif selon l'une des revendications 5 à 9, caractérisé en ce 5 qu'il constitue un spectroscope utilisant comme source lumineuse le faisceau lumineux de travail (15).

**Patentansprüche**

1. Lasermodul (10) mit einer Laserdiode (11) und einer Linse (12), bei welchem die Laserdiode durch deren vordere Fläche einen Lichtstrahl ausstrahlt, der die Linse so durchdringt, dass ein Arbeitslichtstrahl (15) gebildet wird, und ein regelnder Lichtstrahl (18), gebildet durch einen Teil des durch die Laserdiode ausgestrahlten Lichts durch faseroptische Mittel (14) gegen die Regelmittel (40) der Laserdiode führbar sind, und die Regelmittel den regelnden Lichtstrahl verwenden, um mindestens einen Funktionsparameter der Laserdiode zu bestimmen, **dadurch gekennzeichnet, dass**

- die Linse (12) sich vor der vorderen Fläche der Laserdiode befindet und sehr nahe an der Laserdiode (11) angeordnet ist, wodurch erreichbar ist, dass die von der Linse gegen diese Laserdiode (11) zurückgestrahlten Reflexionen wenig störend sind, und
- die Faseroptik (14) mit dem Lasermodul (10) so gekoppelt ist, dass ein Teil des durch die vordere Fläche der Laserdiode ausgestrahlten Lichts aufgefangen wird, welches, ohne die Linse zu durchdringen, durch Reflexionen und/oder Diffusion auf der Linse (12) entstanden ist, und mindestens dieser Teil des Lichts den regelnden Lichtstrahl bildet.

2. Lasermodul nach Anspruch 1, **dadurch gekennzeichnet, dass** die Regelmittel den regelnden Lichtstrahl für die Bestimmung des Injektionsstroms und/oder der Temperatur der Laserdiode (11) verwenden, so dass die Frequenz oder die Wellenlänge des Lichtes (16), das durch die Laserdiode erzeugbar ist, stabilisierbar ist.

3. Lasermodul nach einem der vorhergehenden Ansprüche, **dadurch gekennzeichnet, dass** der optische Weg zwischen der Laserdiode (11) und den Regelmitteln (40) kein Element für eine Strahlenteilung umfassen.

4. Lasermodul nach einem der vorhergehenden Ansprüche, **dadurch gekennzeichnet, dass** ferner das Lasermodul Steuermittel (13) für die Temperatur umfasst, welches erlaubt, gleichzeitig die Temperatur der Laserdiode (11) und der Linse (12) zu steuern.

5. Elektro-optische Mess- oder Übertragungseinrichtung, welche ein Lasermodul (10) nach einem der vorhergehenden Ansprüche umfasst, in welchem der Arbeitslichtstrahl zur Ausübung einer Messung oder einer Übertragung verwendet wird.

6. Einrichtung nach dem vorhergehenden Anspruch, **dadurch gekennzeichnet, dass** die Regelmittel umfassen:

- ein Referenzelement (41),
- optische Überwachungsmittel (42),
- sowie Steuermittel (43) für den Injektionsstrom und/oder die Temperatur der Laserdiode,

wobei der regelnde Lichtstrahl durch die genannte Faseroptik (14) so geführt ist, dass das Referenzelement durchquert und die optischen Detektionsmittel erreicht werden.

7. Einrichtung nach dem vorhergehenden Anspruch, **dadurch gekennzeichnet, dass** das Referenzelement (41) durch eine Absorptionszelle gebildet ist, die einen Atom- oder Molekulardampf enthält und eine spektrale Absorptionsspitze besitzt, in welcher die Frequenz des Lichts (16), erzeugt durch die Laserdiode (11), regelbar ist.

8. Elektro-optische Einrichtung nach einem der Ansprüche 5 bis 7, **dadurch gekennzeichnet, dass** der Arbeitslichtstrahl (15) nach der Linse (12) diskrete optische Komponenten (31, 32, 33, 34, 35) durchquert, die bezüglich der optischen Achse unausgerichtet sind, um ein Feed-back in der Laserdiode einzuschränken.

9. Einrichtung nach einem der Ansprüche 5 bis 8, **dadurch gekennzeichnet, dass** eine zweite Faseroptik (24) mit dem Lasermodul (10) gekoppelt ist, und dass der Arbeitslichtstrahl durch die genannte zweite Faseroptik (24) geführt ist.

10. Einrichtung nach einem der Ansprüche 5 bis 9, **dadurch gekennzeichnet, dass** sie ein Interferometer aufweist, welches als Lichtquelle den Arbeitslichtstrahl (15) verwendet.

11. Einrichtung nach einem der Ansprüche 5 bis 9, **dadurch gekennzeichnet, dass** sie ein Atom-Frequenznormal aufweist, und dass der Arbeitslichtstrahl (15) zum optischen Pumpen einer Resonanzzelle (51) verwendet wird.

12. Einrichtung nach einem der Ansprüche 5 bis 9, **dadurch gekennzeichnet, dass** sie ein faseroptisches Sendegerät (24) aufweist, welches als Lichtquelle den Arbeitslichtstrahl (15) verwendet.

13. Einrichtung nach einem der Ansprüche 5 bis 9, **dadurch gekennzeichnet, dass** sie ein Spektroskop aufweist, welches als Lichtquelle den Arbeitslichtstrahl (15) verwendet.

**Claims**

1. Laser module (10) containing a laser diode (11) and a lens (12), the laser diode emitting by its front face a light beam which passes through the lens in a way so as to constitute an operating light beam (15), a controlling light beam (18) made up of part (17) of the light emitted by the laser diode being conducted by means of an optical fibre (14) toward control means (40) of the laser diode, the control means using the controlling light beam to determine at least one parameter of operation of the laser diode, **char-**

**acterised in that**

- the lens (12) is located in front of the front face of the laser diode and is placed very close to the laser diode (11) in a way so as to make not very irritating the reflections sent back from the lens toward this laser diode (11), and
- the optical fibre (14) is coupled to the laser module (10) in a way so as to collect part of the light emitted by the front face of the laser diode which, without passing through the lens, comes from reflections and/or diffusions on the lens (12), at least this part of the light constituting the controlling light beam.

2. Laser module according to claim 1, **characterised in that** the control means use the controlling light beam to determine the injection current and/or the temperature of the laser diode (11) in a way so as to stabilise the frequency or the wavelength of the light (16) emitted by the laser diode.

3. Laser module according to one of the preceding claims, **characterised in that** the optical path between the laser diode (11) and the control means (40) do not comprise any element of the beam splitting type.

4. Laser module according to one of the preceding claims, **characterised in that** the laser module further comprises means of control of temperature (13) permitting the temperature of the laser diode (11) and of the lens (12) to be controlled simultaneously.

5. Electro-optical device for measuring or transmission comprising a laser module (10) according to one of the preceding claims in which the operating light beam is used to carry out a measurement or a transmission.

6. Device according to the preceding claim, **characterised in that** the control means comprise:

- a reference element (41),
- optical detection means (42),
- as well as means of control (43) of the injection current and(or of the temperature of the laser diode,

the control light beam being guided by the said optical fibre (14) in a way so as to pass through the reference element and to reach the optical detection means.

7. Device according to the preceding claim, **characterised in that** the reference element (41) is made up of a absorption cell containing an atomic or molecular vapour and having a spectral absorption peak to which the frequency of said light emitted (16) by the laser diode (11) is subjected.

8. Device according to one of the claims 5 to 7, **characterised in that** the operating light beam (15) passes through after the lens (12) of discrete optical components (31, 32, 33, 34, 35) misaligned with respect to the optical axis in a way so as to limit the feedback in the laser diode.

9. Device according to one of the claims 5 to 8, **characterised in that** a second optical fibre (24) is coupled to said laser module (10) and **in that** the operating light beam is conveyed by the said second optical fibre (24).

10. Device according to one of the claims 5 to 9, **characterised in that** it comprises an interferometer using the operating light beam (15) as light source.

11. Device according to one of the claims 5 to 9, **characterised in that** it comprises an atomic reference oscillator and **in that** the operating light beam (15) is used to pump optically a resonance cell (51).

12. Device according to one of the claims 5 to 9, **characterised in that** it comprises a transmission emitter on optical fibre (24) using the operating light beam (15) as light source.

13. Device according to one of the claims 5 to 9, **characterised in that** it comprises a spectroscope using the operating light beam (15) as light source.

Fig. 1

EP 0 732 781 B1

Fig. 2

Fig. 3

14

# Fig. 4

EP 0 732 781 B1